# EUROPEAN PATENT APPLICATION

(11) **EP 2 197 253 A1**
(43) Date of publication of application: **16.06.2010**
(21) Application number: 08171451.1
(22) Date of filing: 12.12.2008
(51) Int. Cl.: H05K 3/18, C23C 18/16

(54) **Method for electric circuit deposition**

(71) Applicant: Nederlandse Organisatie voor toegepast -natuurwetenschappelijk onderzoek TNO, 2628 VK Delft (NL)
(72) Inventor: Hovestad, Arjan, 5231 PK 's-Hertogenbosch (NL); Tacken, Roland Anthony, 5663 SH Geldrop (NL)
(74) Representative: Hatzmann, Martin

(57) **Abstract**

The invention is directed to a method for preparing a substrate with an electrically conductive pattern for an electric circuit, to the substrate with the electrically conductive pattern, and to a device comprising the substrate with the electrically conductive pattern.

The method of the invention comprises
(a) providing an electrically insulating or semiconductive substrate, which substrate comprises a distribution of nanoparticles of a first metal or alloy thereof;
(b)
i) locally applying a layer of an inhibiting material onto said substrate; or
ii)
- applying a layer of an inhibiting material onto said substrate, and
- locally removing or deactivating, light-induced, thermally, chemically and/or electrochemically, the layer of inhibiting material and thereby exposing at least part of the first metal or alloy thereof

so as to obtain a pattern for an electric circuit;
(c) depositing by means of an electroless process a layer of a second metal or alloy thereof on the exposed part of the first metal or alloy thereof present in the substrate as obtained in step (b), whereby inhibiting material that is still present on the substrate after step (b) locally inhibits the second metal or alloy thereof to be deposited on the first metal or alloy thereof, ensuring that the second metal or alloy thereof will selectively be deposited on the exposed part of the first metal or alloy thereof as obtained in step (b).

## Description

The invention is directed to a method for preparing a substrate with an electrically conductive pattern for an electric circuit, to said substrate with said electrically conductive pattern, and to a device comprising said substrate with said electrically conductive pattern.

Substrates having electrically conductive patterns thereon are used in a wide variety of electronic applications. Glass substrates used for liquid crystal displays, touch screens for visual displays, solar cells, and consumer electronic displays all require electronically conductive tracks to be formed thereon to provide the desired functionality. Also flexible plastic substrates provided with an electrically conductive pattern have high potential as electronic circuits and electrodes. In particular, plastic substrates having electrically conductive micro-patterns thereon can be used in electronic applications, such as flexible displays, rollable displays, solar panels, smart blisters, radiofrequency identification (RFID) tags, smart labels, electrode arrays for bio-sensing and other sensor applications with distributed transistors pressure sensors, *etc.*

Methods to prepare patterns for electric circuits are well-known. Such patterns can, for instance, be made by providing a dielectric with a metal layer and removing part of the metal layer by means of chemical etching to yield a particular metal circuit pattern. However, there remains a challenge in manufacturing electronic circuitry (electrically conductive tracks) on electrically insulating or semiconductive surfaces, wherein the circuitry has very small feature sizes (such as the maximum width of the tracks and the minimum distance between the tracks), such as feature sizes smaller than 50 µm.

Existing technology for preparing metallic electric circuits with very small feature sizes typically involves photolithography. In photolithography the required circuitry pattern is transferred to a photoresist film applied on a substrate by selective removal of the photoresist. Typically, the substrate is coated with a metallic film and the circuitry is created by etching the metal where photoresist has been removed. Otherwise metal is deposited on the substrate where the photoresist has been removed. Unfortunately, photolithography is not compatible with low-cost roll-to-roll processing, and accordingly these existing manufacturing methods are relatively expensive. In addition, photolithography is not compatible with injection moulding of components. This is particularly disadvantageous, because injection moulding of components can be used for the mass production of electronic components.

US-B-6 605 534, for instance, describes a method in which a semiconductor substrate comprising a via circuit feature is first provided with a continuous metallic seed layer by gas-phase deposition. Then, selected regions of the seed layer are rendered ineffective to plating, *e*.*g*. by locally poisoning the seed layer by exposing the seed layer to a chemical bath and thereby chemically converting select regions of the seed layer into an electroplating inhibitor. Subsequently, a conductive material is deposited using electroplating or electroless plating techniques.

Similarly, Carvalho et al. (Langmuir 2002, 18, 2406-2412) describe preparing patterned electric circuits of less than 20 µm by patterned micro-contact printing of alkanethiol as an inhibitor on palladium films.

However, in both cases removal of the seed layer, by planarization or etching, after electroplating is required to prevent electrical conductivity outside the vias. Moreover, Carvalho *et al*. conclude that patterned inhibition of palladium films by eicosanethiol for electroless deposition of nickel is not feasible, due to unavoidable defects in the inhibiting eicosanethiol layer.

It would be desirable to have an improved method to prepare an electric circuit on an electrically insulating or semiconducting substrate.

Object of the invention is therefore to provide a reliable method for preparing an electric circuit on an electrically insulating or semiconducting substrate which has a small number of processing steps.

Another object of the invention is to provide a method for preparing an electric circuit on an electrically insulating or semiconducting substrate, which method is compatible with roll-to-roll processing or injection moulding of components.

Surprisingly, it has been found that patterned inhibition can advantageously be realised when a distribution of nanoparticles is used as seed for electroless deposition. Although this has been proposed in the non-prepublished European patent application number 07110281.8 the technology described therein is limited to circuitry features having a size larger than about 200 µm due to the mechanic removal of the inhibiting material. In addition, the technology described therein is focussed on 3D-MID (three-dimensional mould interconnect devices) injection mould parts. Non-prepublished European patent application number 08156833.9 describes a similar application on a foil, but the focus is on patterning the foils and not on the application of inhibitor.

In a first aspect the invention is directed to a method for preparing an electrically insulating or semiconducting substrate with an electrically conductive pattern for an electric circuit comprising
(a) providing an electrically insulating or semiconducting substrate, which substrate comprises a distribution of nanoparticles of a first metal or alloy thereof;
(b)
   i) locally applying a layer of an inhibiting material onto said substrate; or
   ii)
      - applying a layer of an inhibiting material onto said substrate, and
      - locally removing, light-induced, thermally, chemically or electrochemically, the layer of inhibiting material and thereby exposing at least part of the first metal or alloy thereof so as to obtain a pattern for an electric circuit;
(c) depositing by means of an electroless process a layer of a second metal or alloy thereof on the exposed part of the first metal or alloy thereof present in the substrate as obtained in step (b), whereby inhibiting material that is still present on the substrate after step (b) locally inhibits the second metal or alloy thereof to be deposited on the first metal or alloy thereof, ensuring that the second metal or alloy thereof will selectively be deposited on the exposed part of the first metal or alloy thereof as obtained in step (b).

The expression "distribution of nanoparticles of a first metal or alloy" as used in this application is meant to refer to a layer on the substrate, which layer comprises islands of nanoparticles. The layer will usually have incomplete coverage, meaning that the layer does not constitute a uniform complete film.

The distribution of nanoparticles of the first metal or alloy thereof can be in the form of a discontinuous layer (*i*.*e*. the distribution of nanoparticles is less than a monolayer of nanoparticles). The advantage thereof is that the amount of processing steps is smaller than *e*.*g*. in US-B-6 605 534. There is no longer a need for applying a resist layer, and for removing resist and seed material. The inventors surprisingly found that it is not possible to locally deactivate a continuous layer of seed material (such as used in US-B-6 605 534), whereas this is possible for a discontinuous layer of seed material, as shown in the Comparative Example below.

The substrate to be used in accordance with the invention can suitably comprise an electrically insulating or semiconductive material, such as a thermoplastic material, a thermosetting material, and/or a ceramic material. Suitable examples of thermoplastic materials include polyethylene terephthalate (PET), polyethylene naphthalate (PEN), polyimide (PI), liquid crystalline polymer (LCP), polyamide (PA) (such as polyamide 6, polyamide 6/6, polyamide 4/6, or polyamide 12), poly(phenylene sulphide) (PPS), polyetherimide (PEI), polybutylene terephthalate (PBT), syndiotactic polystyrene (SPS), polycarbonate (PC), acrylonitrile-butadiene-styrene (ABS), polycarbonate/acrylonitrile-butadiene-styrene (PC/ABS), polypropylene (PP), and polyethylene (PE) polymethylmethacrylate (PMMA), polyamide (PA), polyethersulphones (PES), and polyacrylates. Suitable examples of thermosetting materials include epoxy compounds, melamine, bakelite, and polyester compounds. Preferably, the substrate comprises one or more selected from PET, PEN, PI, LCP, PA, PEI, ABS, PMMA and PC/ABS. Suitable ceramic materials include alumina, zirconia, silica, silicon, sapphire, zinc oxide, tin oxide, chalcopyrites and glass. The substrate can be self-supporting or may be supported by a rigid carrier such as glass, silicon, metal, a thick polymer or the like.

In one embodiment, the substrate is a foil, such as a plastic foil. This can be very advantageous for specific applications, wherein the final electrical circuit should be flexible. The foil can for instance have a thickness of at most 1 mm, preferably at most 500 µm, more preferably at most 250 µm. In order to provide mechanical support it is preferred that the foil has a thickness of at least 5 µm, preferably at least 25 µm.

The first metal or alloy thereof to be used in the method of the invention can suitably comprise one or more selected from the group consisting of cobalt, nickel, iron, tin, copper, rhodium, palladium, platinum, silver, gold, ruthenium, iridium and mixtures thereof. Preferably, the first metal comprises palladium.

The nanoparticles of the first metal or alloy thereof normally have an average particle diameter as measured by transmission electron microscopy in the range of 1-20 nm, more in particular in the range of 2-10 nm.

The distribution of nanoparticles of the first metal or alloy thereof can be established by means of adsorption from a solution of nanoparticles (such as by dip-coating or spraying) or successive dip-coating in a solution of reducing agent, typically divalent tin, and a solution of palladium ions Alternatively, the distribution of nanoparticles of the first metal or alloy thereof can be deposited by conventional metal film deposition techniques (including evaporation, sputtering, vapour deposition (chemical or physical), plasma enhanced deposition and the like). Preferably, the distribution of nanoparticles of the first metal or alloy thereof is established by dip-coating, as this yields a more dense and homogeneous distribution.

Optionally, an adhesion promoter or promoting treatment can be applied between the substrate and the distribution of nanoparticles of the first metal or alloy thereof to improve the adhesion of the nanoparticles of the first metal or alloy thereof on the substrate. Such adhesion promoters are well-known in the art and include *e*.*g*. plasma treatment, UV/ozone treatment, self-assembled monolayers (alkyl or aryl chlorosilanes, alkoxysilanes, Langmuir-Blodgett films, and the like having one or more reactive functional groups such as -OH, -NH₂, -COOH, capable of promoting the adhesion of a third material), polymer coatings, any organic or inorganic coating that has a higher surface energy than the substrate and thereby promotes the adhesion of the nanoparticles of the first metal or alloy thereof.

The inhibiting material to be used in accordance with the method of the invention can suitably comprise any material that is known to inhibit or stabilise electroless deposition processes. Examples of such materials include heavy metal ions, organic and inorganic sulphur-, selenium- or tellur-containing compounds, oxygen-containing compounds and aliphatic and aromatic organic compounds. Preferably, the inhibiting material comprises one or more selected from thiourea, dodecanethiol, hexadecanethiol, octadecanethiol, dipyridil, lead acetate, maleic acid, 2-mercaptobenzimidazole, and 2-mercaptobenzothiazole. Most preferably, the inhibiting material comprises one or more thiol compounds selected from 2-mercaptobenzothiazole, 2-mercaptobenzimidazole dodecanethiol, hexadecanethiol and octadecanethiol.

Suitably, the inhibiting material is chosen such that it is in its least soluble form at the physicochemical conditions of the electroless bath. The inhibiting material is preferably chosen such that at the pH of the electroless bath it is non-ionic and therefore in its least water soluble form. For thiol compounds the degree of ionisation is determined by the acidity of the thiol group as characterised by the pKₐ value. At a pH above the pKₐ, the thiol group is negatively charged resulting in a high solubility in the electroless solution and consequently a low degree of inhibition. As a consequence, hexadecanethiol with a pKₐ > 12 is preferably used in a pH 9-12 electroless copper bath or in acidic, *i*.*e* pH 4-5, electroless nickel baths, but 2-mercaptobenzothiazole with a pKₐ of 7 is preferably only used in acidic, *i*.*e* pH 4-5, electroless nickel baths.

The inhibiting material can be applied from a solution of the inhibiting material in a suitable solvent, such as toluene, benzene, acetone, or an alcohol. Preferably, the solvent comprises an alcohol, such as ethanol, propanol, isopropanol, butanol, pentanol, hexanol, pentanol, octanol, decanol, or mixtures thereof. Most preferably, the solvent comprises one or more selected from ethanol, hexanol and octanol.

The inhibiting material can be dissolved in the solvent in a concentration of 0.1-100 mM, preferably 1-10 mM, more preferably 1-5 mM.

The layer of inhibiting material can suitably be an incomplete adsorbed surface coverage, an adsorbed monolayer or a multilayer. Thus, the layer of inhibiting material can be a uniform layer, but also a layer of incomplete coverage, consisting of multiple, individual or connected parts.

An incomplete surface coverage of inhibiting material can for instance be achieved by applying the inhibiting material locally (such as with a stamp or with a printing method) in a pre-determined pattern in order to obtain a selective metallisation on the areas where no inhibitor is present.

Suitable printing methods include inkjet printing, gravure printing, screen printing, and offset printing. It is also possible to locally apply the inhibiting material by micro-contact printing using a patterned stamp. In this case, a patterned stamp is loaded with the inhibiting material, and subsequently the stamp is brought into contact with the substrate that comprises the distribution of nanoparticles of the first metal or alloy thereof, thereby transferring the pattern of inhibiting material onto the substrate. In this case, the solvents hexanol and octanol were found to give the best results, whereas *e*.*g*. ethanol was found to give the best results for dipping.

In another embodiment, the inhibiting material is applied as a uniform layer (by a printing or dipping method or by using a smooth stamp) and thereafter locally removal or deactivation, either light, thermally, chemically or electrochemically induced. Local light-induced deactivation or local thermal deactivation of the inhibiting layer can be performed *e*.*g*. by laser irradiation or by exposure through a mask. For light-induced removal or deactivation it is preferred to use an ultraviolet light source, while for thermal removal or deactivation an infrared light source is preferred.

It is also possible to locally convert the distribution of nanoparticles of the first metal or alloy thereof via a chemical reaction to an inhibiting compound that does not permit metallisation through an electroless process. In this way, it is possible to arrive at the desired pattern for an electric circuit.

Application of the inhibiting material can suitably be followed by an isotropic etching step (dry or wet) to remove excess inhibiting material, resulting in unprotected areas of the distribution of nanoparticles of the first metal or alloy thereof. An adhesive type material may also be used to remove excess inhibiting material from undesired areas.

The second metal or alloy thereof to be used in the method of the invention can suitably comprise one or more selected from the group consisting of copper, nickel, nickel-phosphorous, nickel-boron, cobalt, tin, silver, gold, palladium, platinum and mixtures thereof. Preferably, the second metal comprises copper, nickel-phosphorous or nickel-boron.

The layer of the second metal or alloy thereof can suitably have a thickness in the range of from 0.05 to 30 µm, more preferably a thickness in the range of from 0.1 to 10 µm. The thickness of the layer of the second metal or alloy thereof can be controlled *e*.*g*. by the deposition time. Usually, the deposition rate is 2-20 µm/h.

The second metal or alloy thereof is applied by an electroless process. During this process inhibiting material that is still present on the substrate locally inhibits the second metal or alloy thereof to be deposited on the first metal or alloy thereof, ensuring that the second metal or alloy thereof will selectively be deposited on the exposed part of the first metal or alloy thereof.

Suitable electroless processes include electroless plating, such as electroless copper, nickel, nickel-phosphorous or nickel boron, silver, tin, cobalt, palladium, platinum or gold plating. In an electroless plating process use is made of the principle that a metal which is available in ionic form in solution can be reduced by a reducing agent into its metallic form on a suitable catalytic surface. Moreover, the metal itself should also be catalytic to the reduction reaction, rendering the process autocatalytic as such. For a general description on electroless plating processes reference can, for instance, be made to Electroless Plating Fundamentals & Applications, edited by Glenn O. Mallory and Juan B. Hajdu, New York (1990).

The electroless process preferably makes use of a solution comprising the second metal or alloy thereof (or a precursor thereof) to be deposited on the distribution of the first metal or alloy thereof. Suitable metal-containing solutions include water-based solutions of copper salts (*e*.*g*. copper sulphate) with formaldehyde as reducing agent and water-based solutions of nickel salts (*e*.*g*. nickel sulphate) with hypophosphite, dimethylaminoborane and/or sodium borohydride as reducing agent.

Optionally, the method of the invention is followed by a step in which inhibiting material is removed from non-metallised areas of the substrate.

When the substrate is a foil it is particularly advantageous to carry out the method of the invention in a roll-to-roll fabrication process. Foils allow processing from a roll while unwinding, processing and rewinding. Conventional methods, in which rigid substrates are used, are not suitable for roll-to-roll fabrication.

In a further aspect the invention is directed to an electric circuit comprising a pattern as prepared by means of the method of the invention. Such an electric circuit can suitably have submicron structures.

In yet a further aspect the invention is directed to an electric device in accordance with the invention. Suitable examples of such devices include but are not limited to flexible devices such as solar cells, displays, organic light emitting diodes (OLEDs). Also encompassed are interconnection parts or sensors for use in vehicles, computers, digital cameras and mobile phones.

### Examples

### Comparative Example 1

A polymer substrate made of a PDMS (polydimethylsiloxane) replica with imprinted features of dimensions (width × length × depth) 1-20 µm × 0.5-1 mm × 350 nm was coated by physical vapour deposition (PVD) with a continuous Pt/Pd film of 15 nm. The substrate was pattern wise coated with an inhibitor material by pressing a PDMS stamp loaded with 2-MBT (2-mercaptobenzothiazole) against the raised areas of the substrate. Subsequently, a layer of nickel was deposited on the substrate in an electroless nickel-boron bath. Metal deposition occurred on the entire Pt/Pd coated substrate both in the raised areas that had been in contact with the 2-MBT loaded PDMS stamp and the recessed areas that had not been in contact with the 2-MBT loaded substrate.

The same result was obtained using continuous Pt/Pd films of 5, 10 and 20 nm.

### Example 1

If, however a discontinuous distribution of palladium catalyst nanoparticles was established on the PDMS replica with imprinted features of dimensions (width × length × depth) 1-20 µm × 0.5-1 mm × 350 nm instead of the Pt/Pd film, it was selective plating with nickel-boron was possible, using the following sequence of process steps:

At first a distribution of palladium catalyst was established on the PDMS using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a PDMS stamp loaded with 2-MBT during 1 minute against the raised area of substrate. The PDMS stamp was loaded with the 2-MBT by exposition to a solution of 5 mM 2-MBT in ethanol during 2 minutes followed by rinsing in ethanol and drying in a N₂ flow.

Subsequently, the substrate was rinsed in demineralised water and a layer of nickel was deposited on the substrate during 5 minutes at 60 °C in an electroless nickel bath having a pH value of 6.1 and containing 24 g/l NiCl₂·6H₂O; 30 g/l C₃H₆O₃ (lactic acid); 15 g/l CH₃COONa (sodium acetate); and 2.5 g/l dimethylammoniumborane. Metal deposition occurred solely in the recessed areas that had not been in contact with the 2-MBT loaded PDMS stamp obtaining a pattern with different track widths.

### Example 2

A polymer substrate made of PET (polyethylene terephthalate) foil, with embossed features of dimensions (width × length × depth) 1-20 µm × 0.5-1 mm × 350 nm was selectively plated with nickel-boron, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a PDMS stamp loaded with 2-MBT during 1 minute against the raised area of substrate. The PDMS stamp was loaded with the 2-MBT by exposition to a solution of 5 mM 2-MBT in ethanol during 2 minutes followed by rinsing in ethanol and drying in a N₂ flow.

Subsequently, the substrate was rinsed in demineralised water and a layer of nickel was deposited on the substrate during 5 minutes at 60 °C in an electroless nickel bath having a pH value of 6.1 and containing 24 g/l NiCl₂·6H₂O; 30 g/l C₃H₆O₃ (lactic acid); 15 g/l CH₃COONa (sodium acetate); and 2.5 g/l dimethylammoniumborane. Metal deposition occurred solely in the embossed areas that had not been in contact with the PDMS stamp obtaining a pattern with different depths and track widths.

### Example 3

A polymer substrate made of PET foil, with embossed features of dimensions (width × length × depth) 1-20 µm × 0.5-1 mm × 350 nm was selectively plated with nickel-phosphorous, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a PDMS stamp loaded with 2-MBT during 1 minute against the raised area of substrate. The PDMS stamp was loaded with the 2-MBT by exposition to a solution of 5 mM 2-MBT in ethanol during 2 minutes followed by rinsing in ethanol and drying in a N₂ flow.

Subsequently, the substrate was rinsed in demineralised water and a layer of nickel was deposited on the substrate during 5 minutes at 90 °C in the commercial electroless nickel bath EN439 (Enthone). Metal deposition occurred solely in the embossed areas that had not been in contact with the PDMS stamp obtaining a pattern with different depths and track widths.

### Example 4

A polymer substrate made of PET foil, with embossed features of dimensions (width × length × depth) 1-20 µm × 0.5-1 mm × 350 nm was selectively plated with nickel-phosphorous, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a PDMS stamp loaded with 2-MBT during 1 minute against the raised area of substrate. The PDMS stamp was loaded with the 2-MBT by exposition to a solution of 5 mM 2-MBT in hexanol during 2 minutes followed by rinsing in ethanol and drying in a N₂ flow.

Subsequently, the substrate was rinsed in demineralised water and a layer of nickel was deposited on the substrate during 5 minutes at 90 °C in the commercial electroless nickel bath EN439 (Enthone). Metal deposition occurred solely in the embossed areas that had not been in contact with the PDMS stamp obtaining a pattern with different depths and track widths.

### Example 5

A polymer substrate made of PET foil was selectively plated with nickel-phosphorous, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a patterned PDMS stamp loaded with 2-MBT during 1 minute against the raised area of substrate. The PDMS stamp was loaded with the 2-MBT by exposition to a solution of 5 mM 2-MBT in ethanol during 2 minutes followed by rinsing in ethanol and drying in a N₂ flow.

Subsequently, the substrate was rinsed in demineralised water and a layer of nickel was deposited on the substrate during 5 minutes at 90 °C in the commercial electroless nickel bath EN439 (Enthone). Metal deposition occurred solely in the areas that had not been in contact with the PDMS stamp obtaining a pattern with different depths and track widths.

### Example 6

A polymer substrate made of PET foil, with embossed features of dimensions (width × length × depth) 1-20 µm × 0.5-1 mm × 350 nm was selectively plated with nickel-phosphorous, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a PDMS stamp loaded with HDT (hexadecanethiol) during 2 minutes against the raised area of substrate. The PDMS stamp was loaded with the HDT by exposition to a solution of 1 mM HDT in ethanol during 2 minutes followed by rinsing in ethanol and drying in a N₂ flow.

Subsequently, the substrate was rinsed in demineralised water and a layer of nickel was deposited on the substrate during 5 minutes at 90 °C in the commercial electroless nickel bath EN439 (Enthone). Metal deposition occurred solely in the embossed areas that had not been in contact with the PDMS stamp.

### Example 7

A polymer substrate made of PET foil was selectively plated with copper, using the following sequence of process steps:

At first a distribution of palladium catalyst was established on the foil using an ionic catalysing process. In order to establish this, the substrate was immersed during 2 minutes in a solution of 10 g/l SnCl₂ and 40 ml/l HCl. After immersion, the sample was rinsed with (demineralised) water during 1 minute. After rinsing, the substrate so obtained was immersed during 1 minute in a solution of 0.25 g/l PdCl₂ and 2.5 ml/l HCl at room temperature. Then, the substrate was rinsed during 1 minute in (demineralised) water. Then, the substrate was pattern wise coated with an inhibitor by pressing a patterned PDMS stamp loaded with 2-MBI (2-mercaptobenzimidazole ) during 1 minute against the substrate. The PDMS stamp was loaded with the 2-MBI by exposition to a solution of 5 mM 2-MBI in hexanol during 2 minutes followed by rinsing in ethanol and drying in a N₂ flow.

Subsequently, the substrate was rinsed in demineralised water and a layer of copper was deposited on the substrate during 5 minutes at 60 °C using an electroless copper bath having a pH value of 9 and containing 8 g/l copper sulphate; 45 g/l triethanolamine; 7 g/l tetraazododecane and 4 g/l dimethylammoniumborane. Metal deposition occurred solely in the areas that had not been in contact with the PDMS stamp.

## Claims

1. Method for preparing an electrically insulating or semiconducting substrate with an electrically conductive pattern for an electric circuit comprising
(a) providing an electrically insulating or semiconducting substrate, which substrate comprises a distribution of nanoparticles of a first metal or alloy thereof;
(b)
i) locally applying a layer of an inhibiting material onto said substrate; or
ii)
- applying a layer of an inhibiting material onto said substrate, and
- locally removing or deactivating, light-induced, thermally, chemically or electrochemically, the layer of inhibiting material and thereby exposing at least part of the first metal or alloy thereof
so as to obtain a pattern for an electric circuit;
(c) depositing by means of an electroless process a layer of a second metal or alloy thereof on the exposed part of the first metal or alloy thereof present in the substrate as obtained in step (b), whereby inhibiting material that is still present on the substrate after step (b) locally inhibits the second metal or alloy thereof to be deposited on the first metal or alloy thereof, ensuring that the second metal or alloy thereof will selectively be deposited on the exposed part of the first metal or alloy thereof as obtained in step (b).

2. Method according to claim 1, wherein said distribution of nanoparticles of the first metal or alloy thereof is established by means of adsorption of nanoparticles or ions from a solution.

3. Method according to claim 1 or 2, wherein the substrate comprises a thermoplastic material, a thermosetting material and/or a ceramic material.

4. Method according to claim 3, wherein the substrate comprises one or more materials selected from the group consisting of polyethylene terephthalate, polyethylene naphthalate, polyimide, polyetherimide, liquid crystalline polymer, polyamide, acrylonitrile-butadiene-styrene, polymethylmethacrylate, polycarbonate/acrylonitrile-butadiene-styrene, epoxy compounds, melamine, bakelite, polyester compounds, alumina, zirconia, silica, silicon, sapphire, zinc oxide, tin oxide, chalcopyrites and glass.

5. Method according to any one of the preceding claims, wherein the substrate has a thickness in the range of 5-500 µm, preferably, 25-250 µm.

6. Method according to any one of the preceding claims, wherein an adhesion promoter or promoting treatment is applied between the substrate and the distribution of nanoparticles of the first metal or alloy thereof.

7. Method according to any one of the preceding claims, wherein the first metal or alloy thereof comprises one or more selected from the group consisting of cobalt, nickel, iron, tin, copper, rhodium, palladium, platinum, ruthenium, iridium silver, gold, and mixtures thereof.

8. Method according to any one of the preceding claims, wherein the inhibiting material comprises one or more selected from the group consisting of heavy metal ions, organic and inorganic sulphur-, selenium- or tellur-containing compounds, oxygen-containing compounds and aliphatic and aromatic organic compounds.

9. Method according to any one of the preceding claims, wherein the inhibiting material is applied to the substrate from a solution comprising one or more solvents selected from the group consisting of ethanol, propanol, isopropanol, butanol, pentanol, hexanol, pentanol, octanol, and decanol.

10. Method according to any one of the preceding claims, wherein the inhibiting material is applied by a printing method or dipping method.

11. Method according to any one of claims 1-9, wherein the inhibiting material is applied by a stamp.

12. Method according to any one of the preceding claims, wherein application of the inhibiting material is followed by an isotropic etching step.

13. Method according to any one of the preceding claims, wherein the second metal or alloy thereof comprises one or more selected from the group consisting of copper, nickel, nickel-phosphorous, nickel-boron, tin, silver, gold, cobalt, palladium, platinum and mixtures thereof.

14. Method according to any one of the preceding claims, further comprising removing of the inhibiting material from non-metallised areas of the substrate after the electroless process.

15. Method according to any one of the preceding claims performed in a roll-to-roll fabrication method.

16. Electrically insulating or semiconductive substrate with an electrically conductive pattern for an electric circuit obtainable by a method according to any one of claims 1-15.

17. Electronic device comprising the electrically insulating or semiconductive substrate with the electrically conductive pattern for an electric circuit according to claim 16.
